# EUROPÄISCHE PATENTSCHRIFT

(11) **EP 3 271 932 B1**
(45) Veröffentlichungstag und Bekanntmachung des Hinweises auf die Patenterteilung: **01.05.2019**
(21) Anmeldenummer: 16710750.7
(22) Anmeldetag: 18.03.2016
(51) Int. Cl.: H01H 47/00, H03K 19/007

(54) **SICHERHEITSSCHALTGERÄT ZUM FEHLERSICHEREN ABSCHALTEN EINER ELEKTRISCHEN LAST**
SAFETY SWITCHING DEVICE FOR FAIL-SAFE DISCONNECTING OF AN ELECTRICAL LOAD
COMMUTATEUR DE SÉCURITÉ POUR INTERROMPRE UNE CHARGE ÉLECTRIQUE SANS ERREUR

(30) Priorität: 20.03.2015 DE 102015104211
(43) Veröffentlichungstag der Anmeldung: 24.01.2018
(73) Patentinhaber: Pilz GmbH & Co. KG, 73760 Ostfildern (DE)
(72) Erfinder: PULLMANN, Juergen, 73760 Ostfildern (DE); ZINSER, Christoph, 73760 Ostfildern (DE); SPATARO, Antonino, 7310 Bad Ragaz (CH); GIGER, Marco, 7310 Bad Ragaz (CH); SCHWENKEL, Hans, 73760 Ostfildern (DE); RUPP, Roland, verstorben (DE)
(74) Vertreter: Witte, Weller & Partner Patentanwälte mbB
(86) Internationale Anmeldenummer: PCT/EP2016/055988
(87) Internationale Veröffentlichungsnummer: WO 2016/150859

(56) Entgegenhaltungen:
- DE-A1-102013 101 932
- DE-B3-102005 048 601
- Dipl.-Ing Eberhard Kirsch et al.: "Sicherheitsrelais -Elementarrelais mit zwangsgeführten Kontakten Besondere Eigenschaften und deren Nutzen", , 2006, Seiten 1-18, XP055273830, Frankfurt Gefunden im Internet: URL:http://www.schaltrelais.de/download/si cherheitsrelais.pdf [gefunden am 2016-05-20] in der Anmeldung erwähnt

## Beschreibung

Die vorliegende Erfindung betrifft ein Sicherheitsschaltgerät zum fehlersicheren Abschalten einer elektrischen Last, mit einem Eingangsteil zum Aufnehmen von zumindest einem sicherheitsrelevanten Eingangssignal, mit einem Logikteil zum Verarbeiten des zumindest einen sicherheitsrelevanten Eingangssignals, und mit einem Ausgangsteil, der eine Relaisspule sowie einen ersten Relaiskontakt, einen zweiten Relaiskontakt, einen dritten Relaiskontakt und einen vierten Relaiskontakt aufweist, wobei der erste und der zweite Relaiskontakt elektrisch in Reihe zueinander angeordnet sind, wobei der dritte und der vierte Relaiskontakt elektrisch in Reihe zueinander angeordnet sind, wobei der erste und der dritte Relaiskontakt mechanisch miteinander gekoppelt sind, um eine erste Gruppe von zwangsgeführten Relaiskontakten zu bilden, wobei der zweite und der vierte Relaiskontakt mechanisch miteinander gekoppelt sind, um eine zweite Gruppe von zwangsgeführten Relaiskontakten zu bilden, und wobei der Logikteil die erste Gruppe von zwangsgeführten Relaiskontakten und die zweite Gruppe von zwangsgeführten Relaiskontakten redundant ansteuert, um in Abhängigkeit von dem zumindest einen sicherheitsrelevanten Eingangssignal wahlweise einen Stromfluss zu der elektrischen Last zu ermöglichen oder fehlersicher zu unterbrechen.

Ein solches Sicherheitsschaltgerät ist beispielsweise aus DE 10 2005 048 601 B3 bekannt.

Sicherheitsschaltgeräte im Sinne der vorliegenden Erfindung werden typischerweise eingesetzt, um eine automatisiert arbeitende technische Anlage, von der im Betrieb eine Gefahr für Leib und Leben von Menschen ausgehen kann, fehlersicher abzuschalten oder anderweitig in einen ungefährlichen Ruhezustand zu bringen. Fehlersicher bedeutet in diesem Zusammenhang, dass das Abschalten der gefahrbringenden Anlage selbst denn gewährleistet sein muss, wenn in den sicherheitsrelevanten Komponenten der Anlage einschließlich des Sicherheitsschaltgerätes ein Fehler auftritt, beispielsweise aufgrund des Ausfalls eines Bauteils oder der Beschädigung eines Kabels. Sicherheitsschaltgeräte unterliegen daher besonderen Anforderungen, die insbesondere in den einschlägigen Normen zur Maschinensicherheit (ISO 13849, IEC 61508 u.a.) definiert sind. Da diese Normen abhängig vom Gefährdungsgrad unterschiedliche Anforderungen definieren, sollen Sicherheitsschaltgeräte im Sinne der vorliegenden Erfindung im Folgenden vor allem solche Geräte sein, die eine Ein-Fehler-Sicherheit im Sinne von SIL3 gemäß IEC 61508 und/oder PL e gemäß ISO 13849 beim sicheren Abschalten einer elektrisch betriebenen Maschine gewährleisten.

Die oben genannte DE 10 2005 048 601 B3 offenbart ein solches Sicherheitsschaltgerät mit einem Logikteil, der zwei Mikrocontroller aufweist. Die zwei Mikrocontroller können über eine Datenverbindung miteinander kommunizieren, um ihre Daten zu vergleichen und sich gegenseitig zu überwachen. Die beiden Mikrocontroller verarbeiten redundant zueinander Eingangssignale, die beispielsweise von einem Not-Aus-Taster, einer Schutztür oder einer Lichtschranke stammen können. Ausgangsseitig steuert jeder Mikrocontroller ein elektromechanisches Sicherheitsrelais mit einer Vielzahl von mechanisch gekoppelten und somit zwangsgeführten Relaiskontakten an. Jeweils ein Schließerkontakt des einen Relais ist in Reihe zu einem Schließerkontakt des anderen Relais angeordnet, so dass die redundant arbeitenden Mikrocontroller einen Stromversorgungspfad zu einer elektrischen Maschine auf zwei Wegen, d.h. zweikanalig abschalten können. Zusätzlich besitzt jedes Relais einen zwangsgeführten Öffnerkontakt, der aufgrund der Zwangsführung immer geöffnet ist, wenn die mechanisch gekoppelten Schließerkontakte geschlossen sind. Die Öffnerkontakte der beiden Sicherheitsrelais sind ebenfalls in Reihe zueinander angeordnet und bilden einen Strompfad, über den ein Überwachungssignal zu den redundanten Mikrocontrollern zurückgeführt ist. Die Mikrocontroller können die geöffnete Kontaktstellung der Schließerkontakte anhand des Überwachungssignals überprüfen, um insbesondere ein Verkleben, Verschweißen oder dergleichen von Schließerkontakten frühzeitig zu erkennen, bevor eine gefährliche elektrische Maschine eingeschaltet wird.

Die Verwendung von zwei separaten elektromechanischen Sicherheitsrelais, die jeweils eine Vielzahl von mechanisch gekoppelten Öffner- und Schließerkontakten besitzen, ist die seit vielen Jahren etablierte Vorgehensweise für die Realisierung von Sicherheitsschaltgeräten im Sinne der vorliegenden Erfindung, wie zum Beispiel eine Publikation der Autoren Eberhard Kirsch, Jürgen Steinhäuser und Friedrich Plappert mit dem Titel "Sicherheitsrelais - Elementarrelais mit zwangsgeführten Kontakten; Besondere Eigenschaften und deren Nutzen", zeigt. Diese Publikation wird vom ZVEI - Zentralverband Elektrotechnik- und Elektronikindustrie e. V., 60528 Frankfurt, unter der Adresse *www.schaltrelais.de*/*download*/*sicherheitsrelais.pdf* bereitgestellt und stammt ausweislich der dortigen Quellenangabe von 2006.

Ein weiterer Überblick über die Verwendung von Sicherheitsrelais zur Gewährleistung der sogenannten funktionalen Sicherheit bei automatisiert betriebenen Anlagen findet sich in der Publikation "Von Europa in die Welt! Funktionale Sicherheit wird zum Leitgedanken", der im November 2014 vom ZVEI veröffentlicht wurde und ebenfalls unter der Internetadresse *www.schaltrelais.de* zu finden ist.

Daneben gibt es seit etwa 15 Jahren Sicherheitsschaltgeräte, die Halbleiter-Schaltelemente anstelle von zwangsgeführten (elektromagnetischen) Relais zum fehlersicheren Abschalten einer elektrischen Last verwenden. Ein Beispiel eines solchen Sicherheitsschaltgerätes ist in EP 1 262 021 B1 beschrieben. Sicherheitsschaltgeräte mit elektromechanischen Sicherheitsrelais besitzen jedoch für manche Anwendungen Vorteile, da sie beispielsweise kein gemeinsames Bezugspotential mit der abzuschaltenden Last benötigen, und sie werden daher auch zukünftig für zahlreiche Anwendungen benötigt.

Die Verwendung von zwei elektromechanischen Sicherheitsrelais, jedes mit einer Vielzahl von mechanisch starr miteinander gekoppelten Schließer- und Öffnerkontakten, ist ein großer Kostenfaktor bei gattungsgemäßen Sicherheitsschaltgeräten mit potentialfreien Ausgängen. Die Kosten für die Sicherheitsrelais machen einen erheblichen Anteil an den gesamten Herstellungskosten für ein Sicherheitsschaltgerät aus.

Vor diesem Hintergrund ist es eine Aufgabe der vorliegenden Erfindung, ein Sicherheitsschaltgerät der eingangs genannten Art anzugeben, das eine Reduzierung der Herstellungskosten ermöglicht.

Gemäß einem Aspekt der vorliegenden Erfindung wird diese Aufgabe durch ein Sicherheitsschaltgerät der eingangs genannten Art gelöst, wobei die Relaisspule mit der ersten Gruppe von zwangsgeführten Relaiskontakten und mit der zweiten Gruppe von zwangsgeführten Relaiskontakten elektromagnetisch gekoppelt ist, so dass der Logikteil den ersten Relaiskontakt, den zweiten Relaiskontakt, den dritten Relaiskontakt und den vierten Relaiskontakt über die eine Relaisspule gemeinsam ansteuern kann, wobei sich der erste und der dritte Relaiskontakt separat von dem zweiten und dem vierten Relaiskontakt bewegen können.

Das neue Sicherheitsschaltgerät verwendet somit eine elektromechanische Relaisanordnung, bei der die redundanten (elektrisch in Reihe zueinander angeordneten) Kontakte zum zweikanaligen Unterbrechen des Strompfades zu der elektrischen Last mit einem gemeinsamen Magnetfeld angesteuert werden, das mit einer gemeinsamen Relaisspule erzeugt wird. Die gemeinsame Relaisspule wird von einem gemeinsamen Steuerstrom durchflossen, den der Logikteil ein- oder ausschalten kann und/oder in der Stromhöhe einstellen kann. Der Logikteil kann die genannten Relaiskontakte daherzumindest in den bevorzugten Ausgestaltungen - mit einem einzigen Steuerstrom ansteuern. Vorzugsweise fließt der gemeinsame Steuerstrom vollständig durch die eine Relaisspule und erzeugt das gemeinsame Magnetfeld, mit dem alle zwangsgeführten und redundanten Relaiskontakte betätigt werden. Die eine Relaisspule besitzt einen Wicklungskörper mit zwei Anschlüssen, vorzugsweise mit genau zwei elektrischen Anschlüssen zum Zu- und Abführen des Steuerstroms. Prinzipiell ist aber auch ein weiterer Anschluss an der Relaisspule denkbar, etwa ein Mittenabgriff.

Überraschenderweise hat sich gezeigt, dass es möglich ist, zwei mechanisch getrennte und separat bewegliche, elektrisch redundant zueinander angeordnete Kontaktgruppen mit einem gemeinsamen Magnetfeld anzusteuern, das mit einer für alle Relaiskontakte gemeinsamen Spule erzeugt wird. Prinzipiell ist es möglich, diese gemeinsame Magnetfeld mit mehreren Steuerströmen zu erzeugen, die sich erst in der Relaisspule addieren und das gemeinsame Magnetfeld erzeugen.

Im Gegensatz zu gattungsgemäßen Sicherheitsschaltgeräten benötigt das neue Sicherheitsschaltgerät nur eine einzige Relaisspule, was die Herstellungskosten senkt, weil das Herstellen von Relaisspulen relativ teuer ist. Vorzugsweise besitzt die eine Relaisspule eine Vielzahl von Windungen, die alle einen gemeinsamen Spulenkern bzw. ein Joch umgeben, das insbesondere aus Ferrit hergestellt ist. Die eine Relaisspule erzeugt somit ein Magnetfeld, das alle angegebenen Relaiskontakte gemeinsam betätigt, wenn die Windungen der einen Relaisspule von dem Steuerstrom durchflossen werden. Dabei betätigt das eine Magnetfeld aber zwei mechanisch voneinander entkoppelte und somit relativ zueinander bewegliche Kontaktgruppen, weshalb das neue Sicherheitsschaltgerät trotz der einen gemeinsamen Relaisspule zwei separate Abschaltpfade aufweist.

In den bevorzugten Ausführungsbeispielen besitzt das neue Sicherheitsschaltgerät nur ein einziges Relaisbauteil, welches alle benötigten Relaiskontakte und die eine Relaisspule unter einer gemeinsamen Staubkappe, d.h. in einem gemeinsamen Bauteilgehäuse bereitstellt. Die Herstellkosten für dieses eine Relaisbauteil liegen in einer ähnlichen Größenordnung wie die Herstellkosten für eines der bislang zwei benötigten Sicherheitsrelais. Da bei dem neuen Sicherheitsschaltgerät in den bevorzugten Ausführungsbeispielen aber nur noch ein solches Relaisbauteil benötigt wird, ist eine deutliche Kosteneinsparung im Vergleich zu gattungsgemäßen Sicherheitsschaltgeräten möglich. Zudem ist auch der Verdrahtungsaufwand beim Zusammenbau des neuen Sicherheitsschaltgerätes reduziert, weil lediglich ein Relaisbauteil auf einer Leiterplatte bestückt werden muss.

Die elektromagnetische Kopplung zwischen der einen Relaisspule und den beiden mechanisch getrennten, relativ zu einander beweglichen Kontaktgruppen kann über einen oder mehrere Klappanker, Drehanker oder dergleichen erfolgen. Klappankerrelais besitzen typischerweise einen verschwenkbar gelagerten Kipphebel, der durch die Federvorspannung der Relaiskontakte in eine Ruheposition vorgespannt ist und der erst durch das Magnetfeld, das der Steuerstrom in der Relaisspule erzeugt, in eine Arbeitsposition verschwenkt wird. Der Klappanker kann mit einem Schieber ausgebildet oder gekoppelt sein, und der Schieber bewegt alle gekoppelten (zwangsgeführten) Relaiskontakte gegen die Federspannung in ihre jeweilige Arbeitsposition. Entfällt der Steuerstrom und damit das Magnetfeld, fallen die Relaiskontakte aufgrund der Federspannung wieder in ihre Ruheposition zurück.

Ein geeignetes Relais für das neue Sicherheitsschaltgerät kann prinzipiell einen gemeinsamen Klappanker für beide Gruppen von zwangsgeführten Relaiskontakten aufweisen. Der gemeinsame Klappanker kann beispielsweise zwei separate, gegeneinander bewegliche Schieber betätigen. Vorteilhaft besitzt die Relaisanordnung in dem neuen Sicherheitsschaltgerät jedoch zwei Anker, wobei jeweils ein Anker eine Gruppe von zwangsgeführten Relaiskontakten betätigt, weil dies eine bessere mechanische Entkopplung zwischen den beiden Gruppen von Relaiskontakten ermöglicht.

Drehankerrelais besitzen einen Anker, der zwischen zwei Jochenden drehbar gelagert ist und über das Magnetfeld der Relaisspule in eine Arbeitsposition verdreht werden kann. In einigen Ausführungsbeispielen kann das neue Sicherheitsschaltgerät ein Drehankerrelais besitzen, wobei die mechanisch voneinander entkoppelten Kontaktgruppen von dem einen Drehanker gemeinsam angesteuert werden. Vorteilhafterweise besitzt das neue Sicherheitsschaltgerät jedoch ein Relais mit zwei Drehankern, die in bevorzugten Ausführungsbeispielen auf einer gemeinsamen Drehachse angeordnet sind. Jeder Drehanker betätigt jeweils nur eine Kontaktgruppe, um auch in diesem Fall eine bessere mechanische Entkopplung zwischen den Kontaktgruppen zu erreichen.

In den bevorzugten Ausführungsbeispielen ist die Relaisspule des neuen Sicherheitsschaltgerätes eine auf dem Spulenkern gleichmäßig, d.h. mit gleichbleibendem Windungsabstand, aufgewickelte Spule. In einigen Ausführungsbeispielen kann die Relaisspule jedoch zwei oder mehr voneinander abgesetzte Wicklungsabschnitte auf dem einen Spulenkern aufweisen, wobei jeweils ein Wicklungsabschnitt einer Gruppe von zwangsgeführten Relaiskontakten zugeordnet sein kann, um eine bessere Entkopplung der Kontaktgruppen zu erreichen. Auch in diesem Fall wird die eine Relaisspule jedoch vorteilhaft von einem gemeinsamen Steuerstrom durchflossen.

Insgesamt besitzt das neue Sicherheitsschaltgerät somit eine Relaisspule, über die zwei redundante Kontaktgruppen betätigt werden, wobei jede der beiden Kontaktgruppen zumindest zwei miteinander zwangsgeführte Relaiskontakte besitzt, und wobei jeweils einer der zwangsgeführten Relaiskontakte der einen Kontaktgruppe mit einem der zwangsgeführten Relaiskontakte der anderen Kontaktgruppe elektrisch in Reihe angeordnet ist. Ein Steuerstrom in der einen Relaisspule erzeugt ein Magnetfeld, mit dem zwei mechanisch voneinander entkoppelte und somit getrennt voneinander bewegbare Kontaktgruppen gemeinsam betätigbar sind. Dabei sind jeweils ein Relaiskontakt der ersten Kontaktgruppe und ein weiterer Relaiskontakt der zweiten Kontaktgruppe in Reihe zueinander angeordnet, um einen Strompfad zu bilden, der von dem Logikteil über die eine Relaisspule zweikanalig unterbrochen werden kann.

Das neue Sicherheitsschaltgerät ist somit funktions- und anschlusskompatibel zu gattungsgemäßen Sicherheitsschaltgeräten, die zwei separate Sicherheitsrelais verwenden. Die Herstellungskosten sind jedoch reduziert, weil nur noch eine Relaisspule benötigt wird. Die oben genannte Aufgabe ist daher vollständig gelöst.

In einer bevorzugten Ausgestaltung besitzt das Sicherheitsschaltgerät ein erstes und ein zweites Schaltelement, die elektrisch in Reihe zu der Relaisspule angeordnet und mit dem Logikteil gekoppelt sind, so dass der Logikteil den Steuerstrom durch die Relaisspule mit dem ersten und/oder mit dem zweiten Schaltelement unterbrechen kann. In den bevorzugten Ausführungsbeispielen sind das erste und das zweite Schaltelement Halbleiterschaltelemente, insbesondere Feldeffekttransistoren. Prinzipiell könnten das erste und/oder zweite Schaltelement jedoch auch andere Halbleiterschaltelemente, wie bipolare Transistoren, oder auch weitere Relaiskontakte sein.

Diese Ausgestaltung ermöglicht auf einfache Weise eine zweikanalige Unterbrechung des einen Steuerstroms für die Relaiskontakte und bietet somit auf kostengünstige Weise einen einfehlersicheren Abschaltpfad, auch wenn nur eine einzige Relaisspule für die Betätigung der redundanten Relaiskontakte verwendet wird. Da gerade die Ausgangsseite eines Sicherheitsschaltgerätes für das fehlersichere Abschalten besonders kritisch ist, stellt der Verzicht auf eine vollständig zweikanalige Realisierung des Ausgangsteils in einem Sicherheitsschaltgerät eine sehr ungewöhnliche Maßnahme für ein Sicherheitsschaltgerät dar. Überraschenderweise hat sich jedoch gezeigt, dass auch mit nur einer einzigen Relaisspule im Ausgangsteil des Sicherheitsschaltgerätes die geforderte Ein-Fehler-Sicherheit erreicht werden kann. Die zweikanalige Unterbrechung des Steuerstroms mit zwei in Reihe zu der Relaisspule angeordneten Schaltelementen ist dafür eine besonders einfache und praktikable Realisierung.

In einer weiteren Ausgestaltung weist der Logikteil einen ersten Auswertekanal und einen zweiten Auswertekanal auf, wobei der erste und der zweite Auswertekanal das erste und das zweite Schaltelement jeweils redundant ansteuern.

In dieser Ausgestaltung wird jedes der beiden redundanten Schaltelemente für sich nochmals redundant angesteuert, was eine besonders zuverlässige und daher vorteilhafte Realisierung ist, um die gewünschte Fehlersicherheit bei dem neuen Sicherheitsschaltgerät zu gewährleisten.

In einer weiteren Ausgestaltung sind das erste Schaltelement stromaufwärts und das zweite Schaltelement stromabwärts von der Relaisspule angeordnet.

Diese Ausgestaltung ist besonders vorteilhaft, weil sie zwei unterschiedliche Abschaltwege an der einen Relaisspule bietet. Einerseits ist eine Abschaltung bei einem Kurzschluss der Relaisspule zur Versorgungsspannung des Sicherheitsschaltgerätes über das zweite, stromabwärts angeordnete Schaltelement möglich. Umgekehrt kann ein Strom durch die Relaisspule über das erste Schaltelement auch dann unterbrochen werden, wenn das Massepotential des Sicherheitsschaltgerätes aufgrund eines Fehlers direkt an der Relaisspule anliegt. Die Ausgestaltung ermöglicht daher auf sehr einfache und kostengünstige Weise eine besonders hohe Fehlersicherheit.

In einer weiteren Ausgestaltung ist der Logikteil dazu ausgebildet, einen momentanen Steuerstrom durch die Relaisspule zu bestimmen und insbesondere zu messen. Vorzugsweise ist der Logikteil in der Lage, den Steuerstrom durch die Relaisspule mithilfe von zumindest einem A/D-Wandler zu bestimmen, d.h. der Logikteil erfasst zumindest einen digitalen Zahlenwert, der den Steuerstrom durch die Relaisspule repräsentiert. In bevorzugten Ausführungsbeispielen ist der Logikteil dazu ausgebildet, den Steuerstrom durch die Relaisspule zweikanalig bzw. redundant zu bestimmen.

Diese Ausgestaltung ermöglicht eine Echtzeitüberwachung des Steuerstroms durch die Relaisspule und trägt damit zu einer besonders hohen Fehlersicherheit vorteilhaft bei. Eine redundante, zweikanalige Bestimmung des Steuerstroms mithilfe von zwei A/D-Wandlern ist darüber hinaus vorteilhaft, weil so auch die einwandfreie Funktion jedes A/D-Wandlers durch einen Plausibilitätsvergleich überwacht werden kann.

In einer weiteren Ausgestaltung besitzt das Sicherheitsschaltgerät einen Shunt-Widerstand, der stromabwärts von dem ersten und zweiten Schaltelement angeordnet ist. Vorzugsweise ist der Shunt-Widerstand auch stromabwärts von der Relaisspule angeordnet.

Diese Ausgestaltung ermöglicht auf sehr einfache und kostengünstige Weise eine Bestimmung des momentanen Steuerstroms durch die Relaisspule. In einigen bevorzugten Ausführungsbeispielen besitzt der Shunt-Widerstand einen elektrischen Widerstand im Bereich zwischen 1 Ohm und 10 Ohm, insbesondere 3 Ohm und maximal 100 Ohm, weil ein niedriger Widerstandswert den Wärmeeintrag in das Sicherheitsschaltgerät für die Strommessung minimiert.

In einer weiteren Ausgestaltung ist der Logikteil dazu ausgebildet, den Steuerstrom durch die Relaisspule auf einen definierten Stromwert zu regeln.

Diese Ausgestaltung ist äußerst ungewöhnlich für den ausgangsseitigen Steuerstrom eines Sicherheitsschaltgerätes mit Relaiskontakten, da es bei einem Sicherheitsschaltgerät im Prinzip nur auf die beiden Zustände "Last ist bestromt" oder "Last ist abgeschaltet" ankommt. Die Regelung des Steuerstroms im Sicherheitsschaltgerät ermöglicht eine Minimierung der Betriebstemperatur des Sicherheitsschaltgerätes und trägt damit zu einer nochmals erhöhten Funktionssicherheit bei.

In einigen Ausführungsbeispielen ist der Logikteil dazu ausgebildet, den Steuerstrom durch die Relaisspule auf den Nennwert des Haltestroms für die Relaiskontakte zu regeln. Dies besitzt den Vorteil, dass ein zuverlässiges Schließen der Relaiskontakte bei minimaler Betriebstemperatur des Sicherheitsschaltgerätes auch dann gewährleistet ist, wenn die Betriebsspannung im Bereich der technischen Anlage schwankt, was beispielsweise bei großen Produktionsmaschinen mit leistungsstarken Motoren der Fall sein kann. In einigen vorteilhaften Ausgestaltungen ist der Logikteil dazu ausgebildet, zumindest eines der oben erwähnten Schaltelemente mit einer Pulsweitenmodulation (PWM) anzusteuern, um den Steuerstrom durch die Relaisspule auf den definierten Stromwert zu regeln. Bevorzugt steuert der Logikteil das zweite, stromabwärts angeordnete Schaltelement mit der Pulsweitenmodulation an, was insbesondere dann vorteilhaft ist, wenn der Steuerstrom durch die Relaisspule im Bereich des zweiten, stromabwärts angeordneten Schaltelements gemessen wird.

In einer weiteren Ausgestaltung ist der Logikteil dazu ausgebildet, eine momentane Spannung an der Relaisspule zu bestimmen, um in Abhängigkeit davon den Steuerstrom durch die Relaisspule zu unterbrechen.

In dieser Ausgestaltung besitzt das neue Sicherheitsschaltgerät eine Spannungsüberwachung, insbesondere eine Überspannungsüberwachung, an der Relaisspule. Bevorzugt besitzt das neue Sicherheitsschaltgerät die Spannungsüberwachung in Ergänzung zu der bereits beschriebenen Messung oder Regelung des Steuerstroms. Die Kombination beider Überwachungen ermöglicht eine besonders hohe Fehlersicherheit und ist wegen der einen Relaisspule kostengünstig möglich.

In einer weiteren Ausgestaltung sind die Relaisspule und der erste, zweite, dritte und vierte Relaiskontakt in einem gemeinsamen Bauteilgehäuse angeordnet, welches zur Bestückung einer Leiterplatte ausgebildet ist. In besonders bevorzugten Ausführungsbeispielen sind insgesamt 6, 8 oder gar 10 Relaiskontakte in dem gemeinsamen Bauteilgehäuse angeordnet, die zwei Kontaktgruppen mit jeweils 3, 4 oder 5 zwangsgeführten Relaiskontakten bilden.

In dieser Ausgestaltung sind die eine Relaisspule und die genannten Relaiskontakte Bestandteile eines Relaisbauteils, welches anstelle der bislang verwendeten zwei Sicherheitsrelais verwendet werden kann. Das Bauteilgehäuse umgibt die Relaisspule, den zumindest einen Anker und die Relaiskontakte und besitzt an seiner Außenseite Löt-und/oder Steckkontakte, die eine Montage auf einer Leiterplatte in einem fachüblichen Bestückungsvorgang ermöglichen. Die Relaisspule und die angegebenen Relaiskontakte bilden somit eine neue Art von Sicherheitsrelais, welches eine besonders kostengünstige Herstellung des neuen Sicherheitsschaltgerätes ermöglicht.

In einer weiteren Ausgestaltung sind der erste und der zweite Relaiskontakt jeweils als Schließerkontakte ausgebildet, und der dritte und der vierte Relaiskontakt sind jeweils als Öffnerkontakte ausgebildet.

In dieser Ausgestaltung besitzt das Sicherheitsschaltgerät in jedem Abschaltpfad zumindest einen zwangsgeführten Öffnerkontakt, der eine Überwachung der Schließerkontakte vor dem Einschalten einer elektrischen Last ermöglicht. Die zwangsgeführte Kopplung zwischen Schließer- und Öffnerkontakt in jedem Abschaltpfad ermöglicht die Überwachung der Arbeitskontakte in einer langjährig bewährten Weise, die zudem kompatibel ist zu gattungsgemäßen Sicherheitsschaltgeräten. Daher kann das Sicherheitsschaltgerät dieser Ausgestaltung sehr einfach als kostengünstiges Austauschgerät für ältere gattungsgemäße Sicherheitsschaltgeräte verwendet werden.

In einer weiteren Ausgestaltung treibt die Relaisspule zumindest einen beweglichen Anker an, der mit den Relaiskontakten mechanisch gekoppelt ist, und der Ausgangsteil weist einen optischen Detektor auf, insbesondere eine Lichtschranke, mit dessen Hilfe der Logikteil zumindest eine Ankerposition des zumindest einen beweglichen Ankers detektieren kann. In bevorzugten Ausführungsbeispielen dieser Ausgestaltung sind der erste, zweite, dritte und vierte Relaiskontakt jeweils Schließerkontakte und der Ausgangsteil kommt ohne zwangsgeführte Öffnerkontakte aus.

In dieser Ausgestaltung erfolgt die Überwachung der Arbeitskontakte mithilfe eines optischen Detektors anstelle der bei gattungsgemäßen Sicherheitsschaltgeräten verwendeten Öffnerkontakte. Die Ausgestaltung ermöglicht einen geringeren Bauraum und einen geringeren Detektorstrom zum Überwachen der Schließerkontakte. Daher kann das Sicherheitsschaltgerät dieser Ausgestaltung kleiner und kompakter realisiert werden. Außerdem reduziert diese Ausgestaltung das unerwünschte Prellen der Relaiskontakte beim Unterbrechen des Laststroms. Der optische Detektor kann vorteilhaft den zumindest einen beweglichen Anker oder ein mechanisch mit dem beweglichen Anker verbundenes Schubglied überwachen. In Ausführungsbeispielen, bei denen das Sicherheitsschaltgerät für jede Kontaktgruppe einen eigenen Anker aufweist, überwacht ein optischer Detektor vorteilhaft alle beweglichen Anker gemeinsam. In einigen vorteilhaften Ausführungsbeispielen besitzen die Anker jeweils eine Durchgangsöffnung, wobei die Durchgangsöffnungen der Anker miteinander fluchten, wenn die Schließerkontakte der Kontaktgruppen geöffnet sind. Im Falle einer Lichtschranke kann das Licht den Lichtempfänger dann nur erreichen, wenn die Durchgangsöffnungen der Anker zumindest teilweise miteinander fluchten.

In einer weiteren Ausgestaltung ist der Logikteil dazu ausgebildet, den Steuerstrom in Abhängigkeit von der zumindest einen Ankerposition einzustellen.

In dieser Ausgestaltung stellt der Logikteil den Steuerstrom durch die Relaisspule unter Berücksichtigung einer momentanen Ankerposition ein, die der Logikteil in einigen Ausführungsbeispielen mithilfe des optischen Detektors detektieren kann. In anderen Ausführungsbeispielen ist der Logikteil dazu ausgebildet, die momentane Ankerposition aus dem gemessenen Stromwert und/oder der zeitlichen Änderung des gemessenen Stromwertes zu bestimmen. Vorteilhaft erhöht der Logikteil den Steuerstrom durch die Relaisspule, wenn ein unerwartetes Abfallen der Schließerkontakte erkannt wird, beispielsweise aufgrund einer starken mechanischen Erschütterung. Die Ausgestaltung ermöglicht auf einfache und kostengünstige Weise eine höhere Verfügbarkeit der überwachten Anlage, indem Fehlabschaltungen vermieden oder zumindest reduziert werden.

In einer weiteren Ausgestaltung beinhaltet der optische Detektor einen Lichtsender und einen Lichtempfänger, die außerhalb des gemeinsamen Bauteilgehäuses des Relaisbauteils angeordnet sind, und der optische Detektor weist ferner einen Lichtleiter auf, der von dem Lichtsender und/oder Lichtempfänger zu dem zumindest einen beweglichen Anker führt.

In dieser Ausgestaltung sind der Lichtsender und der Lichtempfänger außerhalb des Bauteilgehäuses angeordnet, beispielsweise außen am Boden des Relaisbauteils befestigt, und somit vor Verschmutzung und Hitze durch Kontaktabbrand geschützt. Die Lebensdauer des neuen Sicherheitsrelais ist vorteilhaft erhöht.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Ausführungsbeispiele der Erfindung sind in der Zeichnung dargestellt und werden in der nachfolgenden Beschreibung näher erläutert. Es zeigen:
- Fig. 1: die schematische Darstellung eines Ausführungsbeispiels des neuen Sicherheitsschaltgerätes im Zusammenhang mit einem Roboter, von dem im Betrieb eine Gefahr für Menschen ausgeht,
- Fig. 2: das Sicherheitsschaltgerät aus Fig. 1 gemäß einem bevorzugten Ausführungsbeispiel mit einigen Details,
- Fig. 3: weitere Details des Sicherheitsschaltgerätes aus Fig. 2,und
- Fig. 4: ein bevorzugtes Ausführungsbeispiel für ein Relaisbauteil, das die eine Relaisspule und die zwei redundanten, jeweils zwangsgeführten Kontaktgruppen beherbergt.

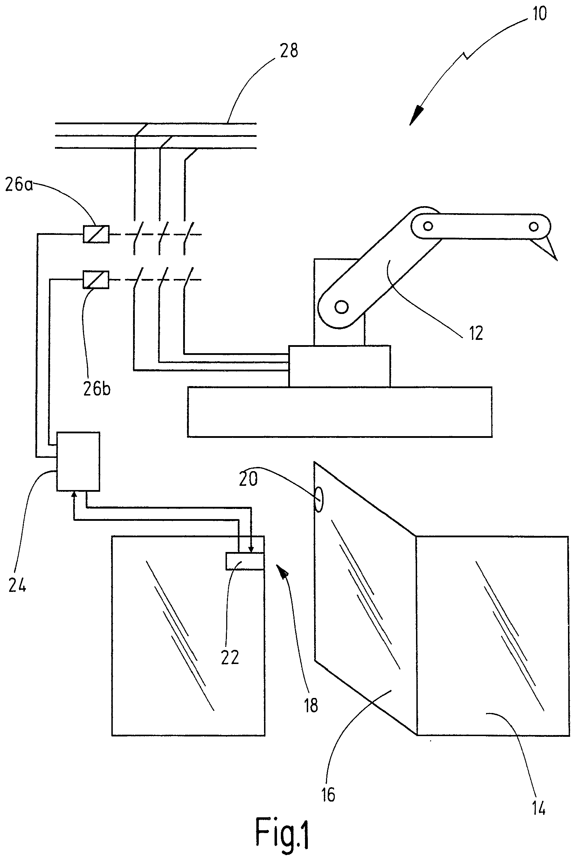

In Fig. 1 ist eine Vorrichtung mit einem Ausführungsbeispiel des neuen Sicherheitsschaltgerätes in ihrer Gesamtheit mit der Bezugsziffer 10 bezeichnet.

Die Vorrichtung 10 beinhaltet hier einen Roboter 12, dessen Bewegungen eine Gefahr für Menschen darstellen, die sich im Arbeitsraum des Roboters 12 aufhalten. Der Roboter 12 ist hier beispielhaft für eine abzusichernde technische Anlage dargestellt. Anstelle eines Roboters 12 kann das neue Sicherheitsschaltgerät auch zum Absichern von anderen Anlagen verwendet werden, insbesondere Anlagen, die unter die Definition der EU-Richtlinie 2006/42/EG (Maschinenrichtlinie) fallen. Ganz allgemein dient das neue Sicherheitsschaltgerät zum fehlersicheren Abschalten einer elektrischen Last, die beispielsweise ein elektrischer Antrieb, ein Schütz und/oder ein Magnetventil in einer solchen Anlage sein kann.

Um das unbeabsichtigte Eindringen einer Person in den gefährlichen Arbeitsbereich des Roboters 12 zu verhindern, ist der Roboter 12 von einem Schutzzaun 14 mit einer Schutztür 16 umgeben. Die Schutztür 10 ist mit einem Schutztürschalter versehen, der ein Türteil 20 und ein Rahmenteil 22 aufweist. Ein Ausführungsbeispiel des neuen Sicherheitsschaltgerätes ist hier mit der Bezugsziffer 24 bezeichnet und über Leitungen mit dem Rahmenteil 22 des Schutztürschalters 18 verbunden. Das Sicherheitsschaltgerät 24 kann mithilfe der Signale von dem Schutztürschalter 18 überwachen, ob die Schutztür 16 geschlossen ist oder nicht. Im letztgenannten Fall soll der Roboter 12 abgeschaltet sein, was mit Hilfe des Sicherheitsschaltgerätes 24 gewährleistet wird.

Ausgangsseitig steuert das Sicherheitsschaltgerät 24 hier zwei Schütze 26a, 26b an. Die Schütze 26a, 26b besitzen jeweils eine Anzahl Arbeitskontakte (typischerweise Schließerkontakte), die im Stromversorgungspfad von einer Stromversorgung 28 zu dem Roboter 12 angeordnet sind. Erkennt das Sicherheitsschaltgerät 24 mit Hilfe des Schutztürschalters 18, dass die Schutztür 16 geöffnet ist, steuert es die Schütze 26a, 26b so an, dass der Roboter 12 von der Stromversorgung 28 getrennt wird.

Die Vorrichtung 10 ist in Fig. 1 vereinfacht dargestellt. Üblicherweise beinhaltet eine solche Vorrichtung 10 nicht nur eine Schutztür mit einem Schutztürschalter 18, sondern eine Vielzahl von sogenannten Meldegeräten und Sensoren, mit denen zahlreiche Zustände der automatisiert betriebenen Anlage detektiert werden. Des Weiteren besitzt die Vorrichtung 10 typischerweise eine Betriebssteuerung, die die Arbeitsbewegungen des Roboters 12 (allgemeiner: der Anlage) steuert. Das Sicherheitsschaltgerät 24 dient hier in Ergänzung zu der Betriebssteuerung (hier nicht dargestellt) dazu, den Betrieb des Roboters 12 soweit abzusichern, dass Unfälle durch Unachtsamkeit, Bauteilversagen u.a. vermieden werden.

Wenn in einer Vorrichtung 10 nur wenige Sicherheitsfunktionen, wie etwa die Schutztürüberwachung und vielleicht ein Not-Aus-Taster, benötigt werden, verwendet man in der Praxis häufig Sicherheitsschaltgeräte, die einen weitgehend vordefinierten, festen Funktionsumfang haben, wie etwa das Überwachen des Schutztürschalters 18. Mehrere Sicherheitsfunktionen werden dann durch Kombination von mehreren Sicherheitsschaltgeräten realisiert. Für komplexe Vorrichtungen haben sich hingegen sogenannte Sicherheitssteuerungen bewährt, deren Funktionsumfang durch Programmieren und/oder Konfigurieren von vordefinierten Funktionsblöcken sehr flexibel festgelegt werden können. Typischerweise besitzen programmierbare und/oder konfigurierbare Sicherheitssteuerungen Halbleiterschaltelemente zum Ansteuern von Schützen 26 und/oder anderen sicherheitsrelevanten Aktoren. Die hier im Folgenden beschriebene Relaistechnik findet heutzutage überwiegend bei relativ einfachen Sicherheitsschaltgeräten mit weitgehend vordefiniertem Funktionsumfang Anwendung. Dessen ungeachtet ist die vorliegende Erfindung aber nicht auf einfache Sicherheitsschaltgeräte dieser Art beschränkt und kann gleichermaßen auch bei komplexen Sicherheitssteuerungen und/oder bei sogenannten I/O-Baugruppen eingesetzt werden, die mit einer komplexen Sicherheitssteuerung über ein Bussystem vernetzt sein können. Daher umfasst der Begriff Sicherheitsschaltgerät im Sinne der vorliegenden Erfindung auch Sicherheitssteuerungen und modulare Komponenten von Sicherheitssteuerungen, die zum fehlersicheren Abschalten einer elektrischen Last im Sinne der vorgenannten Definition dienen. Im Folgenden wird jedoch der Einfachheit halber ein kompaktes Sicherheitsschaltgerät als ein bevorzugtes Ausführungsbeispiel der Erfindung beschrieben.

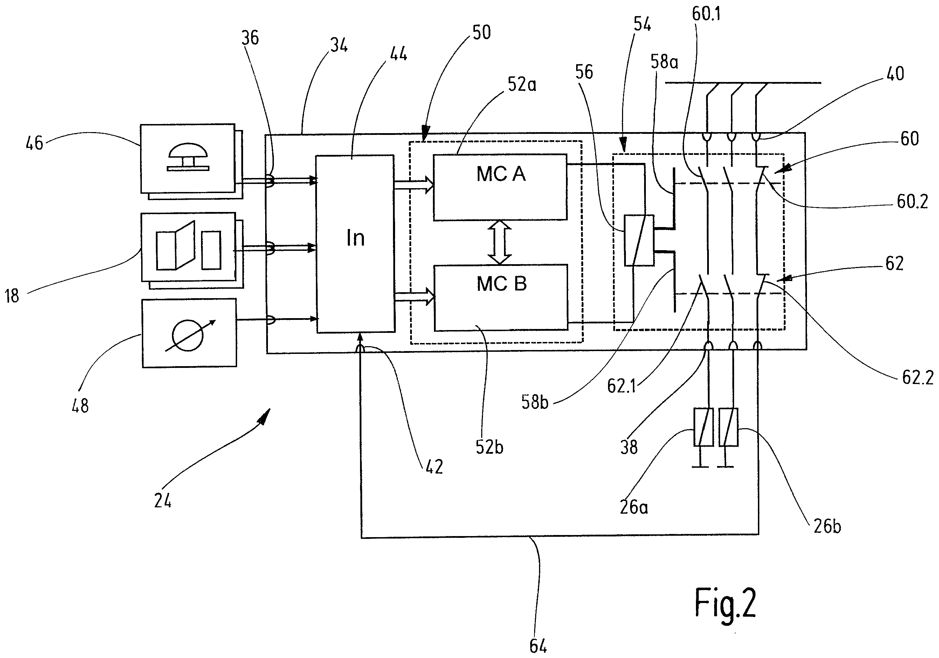

Gemäß Fig. 2 besitzt das Sicherheitsschaltgerät 24 hier ein Gerätegehäuse 34 mit einer Vielzahl von Anschlussklemmen 36, 38, 40, 42, die in bekannter Weise an einer Außenseite des Gerätegehäuses 34 angeordnet sind, um den Anschluss von sicherheitsrelevanten Meldegeräten/Sensoren und sicherheitsrelevanten Aktoren zu ermöglichen. In bevorzugten Ausführungsbeispielen sind die Anschlussklemmen Federkraftklemmen oder Schraubklemmen, die eine lösbare Befestigung von Anschlusskabeln ermöglichen.

Das Sicherheitsschaltgerät 24 besitzt einen Eingangsteil 44, dem die Eingangssignale von den sicherheitsrelevanten Meldegeräten/Sensoren zugeführt sind. Beispielsweise sind die elektrischen Signale von dem Schutztürschalter 18 über entsprechende Anschlussklemmen 36 auf den Eingangsteil 44 geführt. Ergänzend zu dem Schutztürschalter 18 sind hier Not-Aus-Taster 46 und ein fehlersicherer Drehzahlsensor 48 dargestellt.

Der Eingangsteil 44 nimmt die Eingangssignale von den Meldegeräten/Sensoren 18, 46, 48 auf und stellt diese dem Logikteil 50 des Sicherheitsschaltgerätes 24 zur logischen Verarbeitung zur Verfügung. Der Eingangsteil 44 kann beispielsweise Filterschaltungen und/oder eine Pegelanpassung beinhalten. Er bereitet die elektrischen Signale von den Meldegeräten/Sensoren so auf, dass sie vom Logikteil 50 logisch verarbeitet werden können.

Der Logikteil 50 beinhaltet hier zwei Mikrocontroller 52a, 52b, die die Eingangssignale redundant zueinander verarbeiten und sich gegenseitig überwachen können, was hier durch einen Doppelpfeil symbolisch dargestellt ist. Die redundanten Mikrocontroller 52a, 52b zeigen eine typische Realisierung für ein bevorzugtes Ausführungsbeispiel des Sicherheitsschaltgerätes 24. Anstelle von Mikrocontrollern könnten jedoch auch Mikroprozessoren mit zugehöriger Peripherie, FPGAs, ASICS und/oder andere geeignete Logikbauelemente verwendet werden. Auch eine Kombination verschiedener Logikbauelemente ist denkbar, um eine fehlersichere Verarbeitung der Eingangssignale zu realisieren. Darüber hinaus können der Eingangsteil 44 und/oder der Logikteil 50 prinzipiell auch mit diskreten Bauelementen realisiert sein, beispielsweise mithilfe der sogenannten 3-Schütz-Schaltung.

Das Sicherheitsschaltgerät 24 besitzt einen Ausgangsteil 54 mit einer Relaisspule 56, die hier redundant von den beiden Mikrocontrollern 52a, 52b angesteuert wird. In den bevorzugten Ausführungsbeispielen ist die Relaisspule 56 Bestandteil eines Sicherheitsrelais, das als kompaktes Bauelement den Ausgangsteil 54 des Sicherheitsschaltgerätes 24 bildet. Im Folgenden wird daher die Bezugsziffer 54 auch für das eine Sicherheitsrelais verwendet.

Das Sicherheitsrelais 54 besitzt in diesem Ausführungsbeispiel zwei Anker 58a, 58b, die mit der einen Relaisspule 56 jeweils elektromagnetisch gekoppelt sind, so dass ein Steuerstrom durch die Relaisspule 56 sowohl den Anker 58a als auch den Anker 58b betätigen kann. Der Anker 58a ist mechanisch mit einer ersten Gruppe 60 von Relaiskontakten 60.1, 60.2 gekoppelt. Der zweite Anker 58b ist mechanisch mit einer zweiten Gruppe 62 von Relaiskontakten 62.1, 62.2 gekoppelt. Die mechanische Kopplung ist in bekannter Weise so ausgeführt, dass der Anker 58a sämtliche Relaiskontakte 60.1, 60.2 der ersten Gruppe 60 nur gemeinsam betätigen kann. In gleicher Weise ist der Anker 58b mit den Relaiskontakten 62.1, 62.2 der zweiten Gruppe 62 so gekoppelt, dass sämtliche Relaiskontakte 62.1, 62.2 der zweiten Gruppe nur gemeinsam betätigt werden können. Mechanisch sind die Relaiskontakte der ersten Gruppe 60 und die Relaiskontakte der zweiten Gruppe 62 jedoch voneinander entkoppelt, so dass sie sich prinzipiell getrennt voneinander bewegen können. Die gemeinsame Betätigung aller Relaiskontakte 60.1, 60.2, 62.1, 62.2 wird in den bevorzugten Ausführungsbeispielen des Sicherheitsschaltgerätes 24 allein dadurch erreicht, dass ein einzelner Steuerstrom durch die eine Relaisspule 56 ein Magnetfeld erzeugt, das sowohl den ersten Anker 58a als auch den zweiten Anker 58b betätigt.

Die Anker 58a, 58b können Klappanker sein, wie sie hier vereinfacht dargestellt und beispielsweise in der eingangs genannten Publikation "Sicherheitsrelais - Elementarrelais mit zwangsgeführten Kontakten" beschrieben sind. Alternativ oder ergänzend könnten die Anker 58a, 58b Drehanker sein, wie sie beispielsweise von Sicherheitsrelais der Firma Panasonic Electric Works Europa AG bekannt sind. Abweichend von der Darstellung in Fig. 2 können andere Ausführungsbeispiele des Sicherheitsschaltgerätes 24 prinzipiell mit einem einzigen Anker 58 realisiert sein, wobei die Relaiskontakte der ersten Gruppe 60 und die Relaiskontakte der zweiten Gruppe 62 in diesem Fall getrennt mit dem einen Anker gekoppelt sind.

Wie man in der bildlichen Darstellung der Fig. 2 erkennen kann, ist jeweils ein Relaiskontakt der ersten Gruppe 60 in Reihe zu einem Relaiskontakt der zweiten Gruppe 62 angeordnet. Die jeweils in Reihe zueinander angeordneten Relaiskontakte bilden einen Strompfad, den der Logikteil 50 zweikanalig unterbrechen kann, um die Schütze 26a, 26b beim Öffnen der Schutztür 16 abzuschalten.

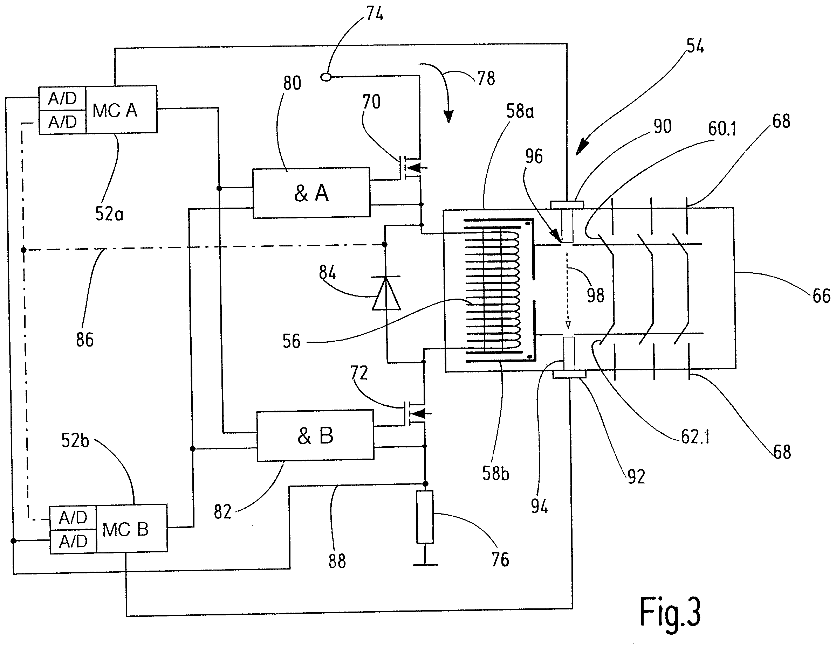

Wie in Fig. 2 weiter dargestellt ist, besitzt das Sicherheitsschaltgerät 24 in einigen Ausführungsbeispielen eine erste Gruppe 60 von Relaiskontakten und eine zweite Gruppe 62von Relaiskontakten, wobei jede Gruppe zumindest einen Schließerkontakt 60.1, 62.1 und zumindest einen Öffnerkontakt 60.2, 62.2 beinhaltet. Die in Reihe zueinander angeordneten Schließerkontakte 60.1, 62.1 bilden einen Strompfad zu der elektrischen Last (hier Schütz 26a), der mithilfe des Sicherheitsschaltgerätes 24 zweikanalig unterbrochen werden kann. Die in Reihe zueinander angeordneten Öffnerkontakte 60.2, 62,2 bilden einen Überwachungsstrompfad, über den ein Überwachungssignal auf den Eingangsteil 44 und/oder den Logikteil 50 zurückgeführt werden kann. Das Überwachungssignal 64 ermöglicht dem Logikteil 50 die Überwachung, ob die Schließerkontakte 60.1, 62.1 vor dem Schließen des Laststrompfades jeweils geöffnet sind, so dass selbst beim Verschweißen oder Verkleben eines Schließerkontaktes 60.1, 62.1 beim Ein- oder Abschalten unter Last noch eine Abschaltmöglichkeit besteht (Ein-Fehler-Sicherheit beim Abschalten). In anderen Ausführungsbeispielen kann das Sicherheitsschaltgerät 24 eine erste Gruppe 60 Relaiskontakte und eine zweite Gruppe 62 Relaiskontakte aufweisen, die ausschließlich als Schließerkontakte ausgebildet sind, wie nachfolgend anhand der Fig. 3 noch erläutert ist. Dabei bezeichnen gleiche Bezugszeichen dieselben Elemente wie zuvor.

Wie in Fig. 3 dargestellt ist, sind die Relaisspule 56, die Anker 58a, 58b und die Relaiskontakte zusammen in einem Bauteilgehäuse 66 angeordnet, an dessen Außenseite Löt-und/oder Steckkontakte 68 angeordnet sind. Das Sicherheitsschaltgerät 24 besitzt in den bevorzugten Ausführungsbeispielen ein einziges Sicherheitsrelais, das über die Kontakte 68 als kompaktes elektromechanisches Bauelement auf einer Leiterplatte (hier nicht dargestellt) befestigt ist. Die weiteren elektrischen Bauelemente des Sicherheitsschaltgerätes 24, wie etwa die Mikrocontroller 52a, 52b sind dann über die Leiterbahnen auf der Leiterplatte (hier nicht dargestellt) mit der Relaisspule 56 verbunden.

In dem dargestellten Ausführungsbeispiel besitzt das Sicherheitsschaltgerät 24 ein erstes Schaltelement 70 und ein zweites Schaltelement 72, die elektrisch jeweils in Reihe zu der Relaisspule 56 angeordnet sind. Das erste Schaltelement 70 ist hier stromaufwärts von der Relaisspule 56 angeordnet, das zweite Schaltelement 72 stromabwärts. Die Reihenschaltung der beiden Schaltelemente 70, 72 mit der Relaisspule 56 liegt zwischen einer Betriebsspannung 74 und Masse. Im dargestellten Ausführungsbeispiel ist stromabwärts von dem zweiten Schaltelement 72 ferner ein Shunt-Widerstand 76 angeordnet, durch den praktisch derselbe Steuerstrom 78 fließt wie durch die Relaisspule 56, wenn die Schaltelemente 70, 72 geschlossen sind. Die Schaltelemente 70, 72 sind hier Feldeffekttransistoren, könnten alternativ jedoch auch andere Schaltelemente sein, vorzugsweise in Haltleitertechnik. In bevorzugten Ausführungsbeispielen steuert jeder Mikrocontroller 52a, 52b (allgemeiner: jeder Auswertekanal des Logikteils 50) jedes der beiden Schaltelemente 70, 72 an. Zu diesem Zweck besitzt das Sicherheitsschaltgerät 24 hier eine erste Treiberschaltung 80 und eine zweite Treiberschaltung 82. Die Treiberschaltungen 80, 82 kombinieren die Ausgangssignale der beiden Mikrocontroller 52a, 52b mit einer logischen UND-Verknüpfung und erzeugen daraus ein Steuersignal, mit dem die Schaltelemente 70, 72 wahlweise leitend oder sperrend gemacht werden. Somit kann hier jeder Mikrocontroller 52a, 52b jedes der beiden Schaltelemente 70, 72 sperren, um den Steuerstrom 78 durch die Relaisspule 56 zu unterbrechen.

Parallel zu der Relaisspule 56 ist in diesem Ausführungsbeispiel eine Freilaufdiode 84 angeordnet, um beim Abschalten der elektrischen Last einen schnelleren Abbau des durch den Steuerstrom 78 induzierten Magnetfeldes zu ermöglichen. An der Kathodenseite der Diode 84 ist in diesem Ausführungsbeispiel ein erster Abgriff 86 vorgesehen, der hier jeweils einem A/D-Wandler der beiden Mikrocontroller 52a, 52b zugeführt ist. Über die A/D-Wandler und den Abgriff 86 kann jeder der Mikrocontroller 52a, 52b die momentane Spannung an der Relaisspule 56 messen. Des Weiteren können die Mikrocontroller 52a, 52b mit Hilfe des Abgriffs 86 prüfen, ob das Schaltelement 70 richtig schaltet.

Ein weiterer Abgriff 88 ist hier zwischen dem zweiten Schaltelement 70 und dem Shunt-Widerstand 76 vorgesehen. Der Abgriff 88 ist hier ebenfalls jeweils einem A/D-Wandler der beiden Mikrocontroller 52a, 52b zugeführt. Die Mikrocontroller 52a, 52b können über den Abgriff 88 die Spannung über dem Shunt-Widerstand 76 messen, die repräsentativ ist für den Steuerstrom 78, der durch die Relaisspule 56 fließt.

Damit ist es alternativ oder ergänzend zu der oben beschriebenen Überwachung des Schaltelements 70 möglich, die Schaltfunktion der Schaltelemente 70, 72 zu überwachen, indem die Mikrocontroller 52a und 52b über den weiteren Abgriff 88 indirekt den Strom messen. In bevorzugten Ausführungsbeispielen sind die Mikrocontroller 52a, 52b ferner dazu ausgebildet, Driftfehler in den Schaltelementen 70, 72 anhand der Strommessung zu erkennen.

In weiteren Ausführungsbeispielen (hier nicht dargestellt) können die Schaltelementen 70, 72 beide stromaufwärts von der einen Relaisspule 56 angeordnet sein. Des Weiteren ist es in einigen Ausführungsbeispielen möglich, dass ein Mikrocontroller den Strom und der andere Mikrocontroller die Spannung an der Relaisspule 56 bestimmt. De zuletzt genannte Variante ist besonders vorteilhaft, wenn die Schaltelemente 70, 72 beide stromaufwärts von der einen Relaisspule 56 angeordnet sind.

In bevorzugten Ausführungsbeispielen ist zumindest einer der Mikrocontroller 52a, 52b dazu ausgebildet, den Strom 78 durch die Relaisspule 56 auf den Nenn-Haltestrom des Relais 54 zu regeln. Besonders vorteilhaft ist es, wenn der entsprechende Mikrocontroller dazu das zweite Schaltelement 72 mit einer Pulsweitenmodulation ansteuert, um den mittleren Stromfluss auf die Höhe des Nenn-Haltestroms des Relais 54 zu regeln.

Wie in Fig. 3 dargestellt ist, besitzt das Relais 54 in einigen Ausführungsbeispielen ausschließlich Schließerkontakte 60.1, 62.1. Anstelle der in Fig. 2 dargestellten zwangsgeführten Öffnerkontakte 60.2, 62.2 besitzt das entsprechende Sicherheitsschaltgerät einen optischen Detektor, der hier als Gabellichtschranke ausgebildet ist. Der optische Detektor besitzt einen Lichtsender 90, beispielsweise in Form einer Leuchtdiode, und einen Lichtempfänger 92. In einigen vorteilhaften Ausführungsbeispielen sind der Lichtsender 90 und der Lichtempfänger 92 außen am Gehäuse 66 des Relais 54 angeordnet. Im Inneren des Relaisgehäuses 66 ist eine Lichtleitfaser 94 angeordnet, die das Licht des Lichtsenders 90 gezielt an eine Stelle bringt, an der die Anker 58a, 58b oder die mit den Ankern betätigten Schieber jeweils eine Durchgangsöffnung 96 aufweisen, die so positioniert ist, dass das Licht 98 den Lichtempfänger 92 nur dann erreichen kann, wenn die Schließerkontakte in beiden Abschaltpfaden geöffnet sind. Das Sicherheitsrelais 54 mit dem optischen Detektor kann aufgrund der einzuhaltenden Isolationsabstände bei gleicher Anzahl an Schließerkontakten kompakter realisiert werden als ein vergleichbares Sicherheitsrelais mit zwangsgeführten Öffnerkontakten.

In einigen vorteilhaften Ausführungsbeispielen ist der Logikteil 50 dazu ausgebildet, den Steuerstrom 78 durch die Relaisspule 56 gezielt zu erhöhen, wenn die Lichtintensität auf dem Lichtempfänger 92 absinkt, während die Schließerkontakte betriebsmäßig geschlossen sind, um beispielsweise im Fall von starken Erschütterungen ein unbeabsichtigtes Abfallen der Relaiskontakte zu verhindern. Alternativ oder ergänzend kann der Logikteil in einigen Ausführungsbeispielen dazu ausgebildet sein, die Ankerposition anhand des Steuerstroms (insbesondere anhand des jeweiligen Momentanwertes des Steuerstroms und einer zeitlichen Änderung des Momentanwertes) zu bestimmen und in Abhängigkeit davon den Steuerstrom 78 durch die Relaisspule 56 gezielt zu erhöhen, um ein unerwünschtes Abfallen der Relaiskontakte zu verhindern.

Zum Abschalten der elektrischen Last genügt es, dass der Logikteil 50 den Steuerstrom 78 durch die Relaisspule 56 auf einen Wert unterhalb des Nenn-Haltestroms absenkt. Vorzugsweise unterbricht der Logikteil 50 den Steuerstrom 78 vollständig. In diesem Fall öffnen die Schließerkontakte des Sicherheitsrelais 54 aufgrund der inhärenten Federvorspannung. Da die beiden Gruppen von zwangsgeführten Relaiskontakten mechanisch entkoppelt sind und sich getrennt voneinander bewegen können, kann der Strompfad zu der elektrischen Last selbst dann geöffnet werden, wenn einer der Schließerkontakte in Folge von Verschweißen, Verkleben oder dergleichen festsitzt. Aufgrund der Überwachung der Schließerkontakte mithilfe der zwangsgeführten Öffnerkontakte (Fig. 2) oder mithilfe des optischen Detektors 90, 92 (fig. 3) kann der Logikteil 50 ein solches Bauteilversagen erkennen, bevor die elektrische Last erneut eingeschaltet wird.

Bevorzugt ist der Logikteil 50 ferner dazu ausgebildet, kurze Abschalttests der Schaltelemente 70, 72 durchzuführen, um im laufenden Betrieb des Sicherheitsschaltgerätes 24 die Abschaltfähigkeit der Schaltelemente 70, 72 wiederholt zu testen. Die Dauer der Abschalttests, d.h. die Dauer der Unterbrechung des Steuerstroms 78, ist vorteilhaft geringer gewählt als die Abfallzeit des Relais 54, so dass der Strompfad zu der Last auch während eines Abschalttests aufgrund der Trägheit des Relais 54 nicht unterbrochen wird. Die Abschaltfähigkeit der Schaltelemente 70, 72 kann mithilfe des Shunt-Widerstands 76 und des Abgriffs 88 vorteilhaft geprüft werden, weil der Steuerstrom durch die Relaisspule beim Öffnen eines Schaltelements 70, 72 auf einen Wert nahe Null absinken muss. Wegen Messfehlern der A/D-Wandler und/oder einem Sperrstrom durch die HalbleiterSchaltelemente 70, 72 kann der gemessene Wert auch bei korrekt funktionierenden Schaltelementen 70, 72 geringfügig größer als Null sein.

In den bevorzugten Ausführungsbeispielen bestimmt der Logikteil 50 außerdem die Höhe des Steuerstroms 78, während die Schaltelemente 70, 72 leitfähig sind. Damit kann der Logikteil 50 auch die Funktionsfähigkeit der A/D-Wandler überprüfen, da die A/D-Wandler in diesem Fall andere Messwerte liefern müssen als bei abgeschaltetem Steuerstrom 78.

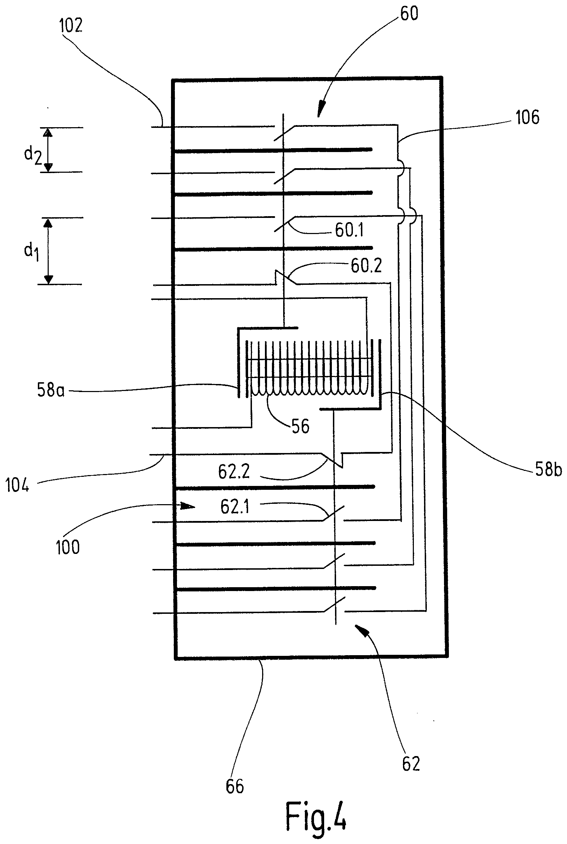

Fig. 4 zeigt ein bevorzugtes Ausführungsbeispiel eines Relaisbauteils mit einem Bauteilgehäuse 66, das die gemeinsame Relaisspule 56 und zwei redundante Kontaktgruppen 60 und 62 beherbergt. Wie man hier sehen kann, ist die Relaisspule 56 räumlich zwischen den beiden Kontaktgruppen 60 und 62 angeordnet. Vorzugsweise, aber nicht zwingend, liegen die Relaisspule 56 und die Relaiskontakte der beiden Kontaktgruppen 60 und 62 in einer gemeinsamen Ebene. Die Relaisspule 56 betätigt hier zwei gegenläufig zueinander verkippbare Anker 58a, 58b, die an gegenüberliegenden Ende der Relaisspule 56 angeordnet sind. In der Darstellung der Fig. 4 schiebt der Anker 58a die Relaiskontakte der ersten Kontaktgruppe 60 in einer ersten Richtung (hier nach oben), während der Anker 58b die Relaiskontakte der zweiten Kontaktgruppe 62 in einer zweiten Richtung (nach unten) verschiebt. Vorzugsweise ist die erste Richtung um 180° gegenüber der zweiten Richtung verdreht. Eine solche räumliche Anordnung ist sehr kompakt und besitzt darüber hinaus den Vorteil, dass die Relaiskontakte der beiden redundanten Kontaktgruppen gegenläufig bewegt werden, was ein unbeabsichtigtes Schließen der Strompfade durch Erschütterung vermeidet.

Das Relaisbauteil gemäß Fig. 4 besitzt insgesamt 8 Kontakte, die in die zwei Kontaktgruppen 60, 62 aufgeteilt sind. In anderen bevorzugten Ausführungsbeispielen besitzt das Relaisbauteil 10 Kontakte, die in zwei Gruppen mit je 5 Kontakten aufteilt sind. Jede Kontaktgruppe 60, 62 besitzt hier 3 zwangsgeführte Schließerkontakte 60.1 bzw. 62.1 sowie einen zwangsgeführten Öffnerkontakt 60.2 bzw. 62.2. Wie man in der Fig. 4 erkennen kann, ist der seitliche Abstand d1 des Öffnerkontakts 60.2 zu dem benachbarten Schließerkontakt 60.1 größer als der seitliche Abstand d2 von zwei benachbarten Schließerkontakten. Dies ist vorteilhaft, damit über die Schließerkontakte höhere Ströme und Spannungen geschaltet werden können als über den Öffnerkontakt einer Gruppe, ohne das die Fehlersicherheit des Relaisbauteils in Bezug auf das Rücklesen der Kontaktstellung mit Hilfe des Öffnerkontakts beeinträchtigt wird. Vorteilhaft ist zudem jeder Kontakt in einer eigenen Kammer 100 angeordnet, um die Isolation zwischen den Kontaktpfaden weiter zu erhöhen.

Des Weiteren ist es hier von Vorteil, dass die elektrische Verbindung zwischen den jeweils in Reihe angeordneten Schließerkontakten 60.1, 62.1 sowie die elektrische Verbindung zwischen den beiden in Reihe angeordneten Öffnerkontakten 60.2, 62.2 innerhalb des Bauteilgehäuses realisiert ist, so dass das Relaisbauteil für jeden geschalteten Strompfad nur zwei Anschlüsse 102, 104 besitzt. In dem bevorzugten Ausführungsbeispiel ist die serielle Verbindung zwischen zwei redundanten Kontakten 60.1, 62.1 mit Hilfe von leitfähigen Blechteilen 106 realisiert.

Des Weiteren sind alle Anschlüsse des Relaisbauteils in diesem vorteilhaften Ausführungsbeispiel an einer Seite des Bauteilgehäuses 66 herausgeführt, so dass das Relaisbauteil in dem Sicherheitsschaltgerät 24 einfach montiert und verlötet werden kann.

## Patentansprüche

1. Sicherheitsschaltgerät zum fehlersicheren Abschalten einer elektrischen Last (26), mit einem Eingangsteil (44) zum Aufnehmen von zumindest einem sicherheitsrelevanten Eingangssignal, mit einem Logikteil (50) zum Verarbeiten des zumindest einen sicherheitsrelevanten Eingangssignals, und mit einem Ausgangsteil (54), der eine Relaisspule (56) sowie einen ersten Relaiskontakt (60.1), einen zweiten Relaiskontakt (62.1), einen dritten Relaiskontakt (60.2) und einen vierten Relaiskontakt (62.2) aufweist, wobei der erste und der zweite Relaiskontakt (60.1, 62.1) elektrisch in Reihe zueinander angeordnet sind, wobei der dritte und der vierte Relaiskontakt (60.2, 62.2) elektrisch in Reihe zueinander angeordnet sind, wobei der erste und der dritte Relaiskontakt (60.1, 60.2) mechanisch miteinander gekoppelt sind, um eine erste Gruppe (60) von zwangsgeführten Relaiskontakten zu bilden, wobei der zweite und der vierte Relaiskontakt (62.1, 62.2) mechanisch miteinander gekoppelt sind, um eine zweite Gruppe (62) von zwangsgeführten Relaiskontakten zu bilden, und wobei der Logikteil (50) die erste Gruppe (60) von zwangsgeführten Relaiskontakten und die zweite Gruppe (62) von zwangsgeführten Relaiskontakten redundant ansteuert, um in Abhängigkeit von dem zumindest einen sicherheitsrelevanten Eingangssignal wahlweise einen Stromfluss zu der elektrischen Last (24) zu ermöglichen oder fehlersicher zu unterbrechen, **dadurch gekennzeichnet, dass** die Relaisspule (56) mit der ersten Gruppe (60) von zwangsgeführten Relaiskontakten und mit der zweiten Gruppe (62) von zwangsgeführten Relaiskontakten elektromagnetisch gekoppelt ist, so dass der Logikteil (50) den ersten Relaiskontakt (60.1), den zweiten Relaiskontakt (62.1), den dritten Relaiskontakt (60.2) und den vierten Relaiskontakt (62.2) über die eine Relaisspule (56) gemeinsam ansteuern kann, wobei sich der erste und der dritte Relaiskontakt (60.1, 60.2) mechanisch separat von dem zweiten und dem vierten Relaiskontakt (62.1, 62.2) bewegen können.

2. Sicherheitsschaltgerät nach Anspruch 1, **gekennzeichnet durch** ein erstes und ein zweites Schaltelement (70, 72), die elektrisch in Reihe zu der Relaisspule (56) angeordnet und mit dem Logikteil (50) gekoppelt sind, so dass der Logikteil (50) einen Steuerstrom (78) durch die Relaisspule (56) mit dem ersten und/oder mit dem zweiten Schaltelement (70, 72) unterbrechen kann.

3. Sicherheitsschaltgerät nach Anspruch 2, **dadurch gekennzeichnet, dass** der Logikteil (50) einen ersten Auswertekanal (52a) und einen zweiten Auswertekanal (52b) aufweist, wobei der erste und der zweite Auswertekanal (52a, 52b) das erste und das zweite Schaltelement (70, 72) jeweils redundant ansteuern.

4. Sicherheitsschaltgerät nach Anspruch 2 oder 3, **dadurch gekennzeichnet, dass** das erste Schaltelement (70) stromaufwärts und das zweite Schaltelement (72) stromabwärts von der Relaisspule (56) angeordnet ist.

5. Sicherheitsschaltgerät nach einem der Ansprüche 2 bis 4, **gekennzeichnet durch** einen Shunt-Widerstand (76), der stromabwärts von dem ersten und zweiten Schaltelement (70, 72) angeordnet ist.

6. Sicherheitsschaltgerät nach einem der Ansprüche 1 bis 5, **dadurch gekennzeichnet, dass** der Logikteil (50) dazu ausgebildet ist, einen momentanen Steuerstrom (78) durch die Relaisspule (56) zu bestimmen.

7. Sicherheitsschaltgerät nach einem der Ansprüche 1 bis 6, **dadurch gekennzeichnet, dass** der Logikteil (50) dazu ausgebildet ist, einen Steuerstrom (78) durch die Relaisspule (56) auf einen definierten Stromwert zu regeln.

8. Sicherheitsschaltgerät nach einem der Ansprüche 1 bis 7, **dadurch gekennzeichnet, dass** der Logikteil (50) dazu ausgebildet ist, eine momentane Spannung an der Relaisspule (56) zu bestimmen, um in Abhängigkeit davon einen Steuerstrom (78) durch die Relaisspule (56) zu unterbrechen.

9. Sicherheitsschaltgerät nach einem der Ansprüche 1 bis 8, **dadurch gekennzeichnet, dass** die Relaisspule (56) und der erste, zweite, dritte und vierte Relaiskontakt (60.1, 60.2, 62.1, 62.2) in einem gemeinsamen Bauteilgehäuse (66) angeordnet sind, welches zur Bestückung einer Leiterplatte ausgebildet ist.

10. Sicherheitsschaltgerät nach einem der Ansprüche 1 bis 9, **dadurch gekennzeichnet, dass** der erste und der zweite Relaiskontakt (60.1, 62.1) jeweils als Schließerkontakte ausgebildet sind, und dass der dritte und der vierte Relaiskontakt (60.2, 62.2) jeweils als Öffnerkontakte ausgebildet sind.

11. Sicherheitsschaltgerät nach einem der Ansprüche 1 bis 10, **dadurch gekennzeichnet, dass** die Relaisspule (56) zumindest einen beweglichen Anker (58) antreibt, der mit den Relaiskontakten (60.1, 62.1, 60.2, 62.2) gekoppelt ist, und dass der Ausgangsteil (54) einen optischen Detektor (90, 92) aufweist, insbesondere eine Lichtschranke, mit dessen Hilfe der Logikteil (50) zumindest eine Ankerposition des zumindest einen beweglichen Ankers (58) detektieren kann.

12. Sicherheitsschaltgerät nach Anspruch 11, **dadurch gekennzeichnet, dass** der optische Detektor einen Lichtsender (90) und einen Lichtempfänger (92) beinhaltet, die außerhalb des gemeinsamen Bauteilgehäuses (66) angeordnet sind, und dass der optische Detektor ferner einen Lichtleiter (94) aufweist, der von dem Lichtsender (90) und/oder Lichtempfänger (92) zu dem zumindest einen beweglichen Anker (58) führt.

13. Sicherheitsschaltgerät nach einem der Ansprüche 1 bis 12, **dadurch gekennzeichnet, dass** die Relaisspule (56) zumindest einen beweglichen Anker (58) antreibt, der mit den Relaiskontakten (60.1, 62.1, 60.2, 62.2) gekoppelt ist, und dass der Logikteil (50) dazu ausgebildet ist, einen Steuerstrom (78) durch die Relaisspule (56) in Abhängigkeit von der zumindest einen Ankerposition einzustellen.

14. Sicherheitsschaltgerät nach einem der Ansprüche 1 bis 13, **dadurch gekennzeichnet, dass** die Relaisspule (56) räumlich zwischen der ersten Gruppe (60) von zwangsgeführten Relaiskontakten (60.1, 60.2) und der zweite Gruppe (62) von zwangsgeführten Relaiskontakten (62.1, 62.2) angeordnet ist.

15. Relaisbauteil für ein Sicherheitsschaltgerät nach einem der Ansprüche 1 bis 14, mit einer Relaisspule (56) und mit einem ersten Relaiskontakt (60.1), einem zweiten Relaiskontakt (62.1), einem dritten Relaiskontakt (60.2) und einem vierten Relaiskontakt (62.2), und mit einem Bauteilgehäuse (66) in dem die Relaisspule (56) und die Relaiskontakte (60.1, 60.2, 62.1, 62.2) untergebracht sind, wobei der erste und der zweite Relaiskontakt (60.1, 62.1) elektrisch in Reihe zueinander angeordnet sind, wobei der dritte und der vierte Relaiskontakt (60.2, 62.2) elektrisch in Reihe zueinander angeordnet sind, wobei der erste und der dritte Relaiskontakt (60.1, 60.2) mechanisch miteinander gekoppelt sind, um eine erste Gruppe (60) von zwangsgeführten Relaiskontakten zu bilden, wobei der zweite und der vierte Relaiskontakt (62.1, 62.2) mechanisch miteinander gekoppelt sind, um eine zweite Gruppe (62) von zwangsgeführten Relaiskontakten zu bilden, und wobei die Relaisspule (56) mit der ersten Gruppe (60) von zwangsgeführten Relaiskontakten und mit der zweiten Gruppe (62) von zwangsgeführten Relaiskontakten elektromagnetisch gekoppelt ist, so dass ein Steuerstrom in der Relaisspule (56) den ersten Relaiskontakt (60.1), den zweiten Relaiskontakt (62.1), den dritten Relaiskontakt (60.2) und den vierten Relaiskontakt (62.2) gemeinsam ansteuern kann, wobei sich der erste und der dritte Relaiskontakt (60.1, 60.2) mechanisch separat von dem zweiten und dem vierten Relaiskontakt (62.1, 62.2) bewegen können.

## Claims

1. A safety switching device for fail-safely disconnecting an electrical load (26), comprising an input part (44) for receiving at least one safety-relevant input signal, comprising a logic part (50) for processing the at least one safety-relevant input signal, and comprising an output part (54) which comprises a relay coil (56) and a first relay contact (60.1), a second relay contact (62.1), a third relay contact (60.2), and a fourth relay contact (62.2), wherein the first and the second relay contacts (60.1, 62.1) are arranged electrically in series with one another, wherein the third and the fourth relay contacts (60.2, 62.2) are arranged electrically in series with one another, wherein the first and the third relay contacts (60.1, 60.2) are mechanically coupled to each other so as to form a first group (60) of positively driven relay contacts, wherein the second and the fourth relay contacts (62.1, 62.2) are mechanically coupled to each other so as to form a second group (62) of positively driven relay contacts, and wherein the logic part (50) redundantly controls the first group (60) of positively driven relay contacts and the second group (62) of positively driven relay contacts in order to selectively allow, or to interrupt in a fail-safe manner, a current flow to the electrical load (24), depending on the at least one safety-relevant input signal, **characterized in that** the relay coil (56) is electromagnetically coupled to the first group (60) and to the second group (62) of positively driven relay contacts in such a manner that the logic part (50) can together control the first relay contact (60.1), the second relay contact (62.1), the third relay contact (60.2), and the fourth relay contact (62.2) via said one relay coil (56), wherein the first and the third relay contacts (60.1, 60.2) can move mechanically separately from the second and the fourth relay contacts (62.1, 62.2).

2. The safety switching device of claim 1, **characterized by** a first and a second switching element (70, 72) which are arranged electrically in series with the relay coil (56) and are coupled to the logic part (50) in such a manner that the logic part (50) can interrupt a control current (78) through the relay coil (56) using the first and/or the second switching element (70, 72).

3. The safety switching device of claim 2, **characterized in that** the logic part (50) comprises a first evaluation channel (52a) and a second evaluation channel (52b), wherein the first and the second evaluation channels (52a, 52b) each redundantly control the first and the second switching elements (70, 72).

4. The safety switching device of claim 2 or 3, **characterized in that** the first switching element (70) is situated upstream and the second switching element (72) is situated downstream from the relay coil (56).

5. The safety switching device of one of claims 2 to 4, **characterized by** a shunt resistor (76) which is situated downstream from the first and the second switching elements (70, 72).

6. The safety switching device of one of claims 1 to 5, **characterized in that** the logic part (50) is configured to determine an instantaneous control current (78) through the relay coil (56).

7. The safety switching device of one of claims 1 to 6, **characterized in that** the logic part (50) is configured to maintain a control current (78) through the relay coil (56) at a defined current value.

8. The safety switching device of one of claims 1 to 7, **characterized in that** the logic part (50) is configured to determine an instantaneous voltage at the relay coil (56), in order to interrupt, depending thereon, a control current (78) through the relay coil (56).

9. The safety switching device of one of claims 1 to 8, **characterized in that** the relay coil (56) and the first, second, third, and fourth relay contacts (60.1, 60.2, 62.1, 62.2) are accommodated in a common component housing (66) which is designed to be mounted on a circuit board.

10. The safety switching device of one of claims 1 to 9, **characterized in that** the first and second relay contacts (60.1, 62.1) each are designed as normally open contacts, and the third and the fourth relay contacts (60.2, 62.2) each are designed as normally closed contacts.

11. The safety switching device of one of claims 1 to 10, **characterized in that** the relay coil (56) drives at least one movable armature (58) which is coupled to the relay contacts (60.1, 62.1, 60.2, 62.2), and the output part (54) comprises an optical detector (90, 92), in particular a light barrier, with the aid of which the logic part (50) can detect at least one armature position of the at least one movable armature (58).

12. The safety switching device of claim 11, **characterized in that** the optical detector comprises a light transmitter (90) and a light receiver (92) which are situated outside the common component housing (66), and the optical detector further comprises an optical waveguide (94) which extends from the light transmitter (90) and/or light receiver (92) to the at least one movable armature (58).

13. The safety switching device of one of claims 1 to 12, **characterized in that** the relay coil (56) drives at least one movable armature (58) which is coupled to the relay contacts (60.1, 62.1, 60.2, 62.2), and the logic part (50) is configured to adjust a control current (78) through the relay coil (56) depending on the at least one armature position.

14. The safety switching device of one of claims 1 to 13, **characterized in that** the relay coil (56) is spatially situated between the first group (60) of positively driven relay contacts (60.1, 60.2) and the second group (62) of positively driven relay contacts (62.1, 62.2).

15. A relay component for a safety switching device according to one of claims 1 to 14, comprising a relay coil (56) and a first relay contact (60.1), a second relay contact (62.1), a third relay contact (60.2), and a fourth relay contact (62.2), and comprising a component housing (66), in which the relay coil (56) and the relay contacts (60.1, 60.2, 62.1, 62.2) are accommodated, wherein the first and the second relay contacts (60.1, 62.1) are arranged electrically in series with one another, wherein the third and the fourth relay contacts (60.2, 62.2) are arranged electrically in series with one another, wherein the first and the third relay contacts (60.1, 60.2) are mechanically coupled to each other so as to form a first group (60) of positively driven relay contacts, wherein the second and the fourth relay contacts (62.1, 62.2) are mechanically coupled to each other so as to form a second group (62) of positively driven relay contacts, and wherein the relay coil (56) is electromagnetically coupled to the first group (60) of positively driven relay contacts and to the second group (62) of positively driven relay contacts in such a manner that a control current in the relay coil (56) can control the first relay contact (60.1), the second relay contact (62.1), the third relay contact (60.2), and the fourth relay contact (62.2) together, wherein the first and the third relay contacts (60.1, 60.2) can move mechanically separately from the second and the fourth relay contacts (62.1, 62.2).

## Revendications

1. Commutateur de sécurité pour la mise hors circuit avec protection contre les défauts d'une charge électrique (26), comprenant une partie d'entrée (44) destinée à accueillir au moins un signal d'entrée concernant la sécurité, comprenant une partie logique (50) destinée à traiter l'au moins un signal d'entrée concernant la sécurité, et comprenant une partie de sortie (54) qui possède une bobine de relais (56) ainsi qu'un premier contact de relais (60.1), un deuxième contact de relais (62.1), un troisième contact de relais (60.2) et un quatrième contact de relais (62.2), les premier et deuxième contacts de relais (60.1, 62.1) étant disposés électriquement en série l'un avec l'autre, les troisième et quatrième contacts de relais (60.2, 62.2) étant disposés électriquement en série l'un avec l'autre, les premier et troisième contacts de relais (60.1, 60.2) étant couplés mécaniquement l'un à l'autre afin de former un premier groupe (60) de contacts de relais à guidage forcé, les deuxième et quatrième contacts de relais (62.1, 62.2) étant couplés mécaniquement l'un à l'autre afin de former un deuxième groupe (62) de contacts de relais à guidage forcé, et la partie logique (50) excitant de manière redondante le premier groupe (60) de contacts de relais à guidage forcé et le deuxième groupe (62) de contacts de relais à guidage forcé afin de, en fonction de l'au moins un signal d'entrée concernant la sécurité, au choix permettre un flux de courant vers la charge électrique (24) ou de l'interrompre avec protection contre les défauts, **caractérisé en ce que** la bobine de relais (56) est couplée de manière électromagnétique avec le premier groupe (60) de contacts de relais à guidage forcé et avec le deuxième groupe (62) de contacts de relais à guidage forcé, de sorte que la partie logique (50) peut exciter conjointement le premier contact de relais (60.1), le deuxième contact de relais (62.1), le troisième contact de relais (60.2) et le quatrième contact de relais (62.2) par le biais de ladite bobine de relais (56), les premier et troisième contacts de relais (60.1, 60.2) pouvant se déplacer mécaniquement séparément des deuxième et quatrième contacts de relais (62.1, 62.2).

2. Commutateur de sécurité selon la revendication 1, **caractérisé par** un premier et un deuxième élément de commutation (70, 72) qui sont disposés électriquement en série avec la bobine de relais (56) et sont couplés avec la partie logique (50) de telle sorte que la partie logique (50) peut interrompre un courant de commande (78) à travers la bobine de relais (56) avec le premier et/ou avec le deuxième élément de commutation (70, 72).

3. Commutateur de sécurité selon la revendication 2, **caractérisé en ce que** la partie logique (50) possède un premier canal d'interprétation (52a) et un deuxième canal d'interprétation (52b), les premier et deuxième canaux d'interprétation (52a, 52b) excitant respectivement de manière redondante les premier et deuxième éléments de commutation (70, 72).

4. Commutateur de sécurité selon la revendication 2 ou 3, **caractérisé en ce que** le premier élément de commutation (70) est disposé électriquement en amont de la bobine de relais (56) et le deuxième élément de commutation (72) électriquement en aval.

5. Commutateur de sécurité selon l'une des revendications 2 à 4, **caractérisé par** une résistance shunt (76) qui est disposée électriquement en aval des premier et deuxième éléments de commutation (70, 72).

6. Commutateur de sécurité selon l'une des revendications 1 à 5, **caractérisé en ce que** la partie logique (50) est configurée pour déterminer un courant de commande (78) momentané à travers la bobine de relais (56).

7. Commutateur de sécurité selon l'une des revendications 1 à 6, **caractérisé en ce que** la partie logique (50) est configurée pour réguler un courant de commande (78) à travers la bobine de relais (56) à une valeur de courant définie.

8. Commutateur de sécurité selon l'une des revendications 1 à 7, **caractérisé en ce que** la partie logique (50) est configurée pour déterminer une tension momentanée aux bornes de la bobine de relais (56) afin d'interrompre un courant de commande (78) à travers la bobine de relais (56) en fonction de celle-ci.

9. Commutateur de sécurité selon l'une des revendications 1 à 8, **caractérisé en ce que** la bobine de relais (56) et les premier, deuxième, troisième et quatrième contacts de relais (60.1, 60.2, 62.1, 62.2) sont disposés dans un boîtier de composant (66) commun qui est configuré pour équiper une carte à circuit imprimé.

10. Commutateur de sécurité selon l'une des revendications 1 à 9, **caractérisé en ce que** les premier et deuxième contacts de relais (60.1, 62.1) sont respectivement réalisés sous la forme de contacts à fermeture et **en ce que** les troisième et quatrième contacts de relais (60.2, 62.2) sont respectivement réalisés sous la forme de contacts à ouverture.

11. Commutateur de sécurité selon l'une des revendications 1 à 10, **caractérisé en ce que** la bobine de relais (56) entraîne au moins un induit (58) mobile qui est couplé avec les contacts de relais (60.1, 62.1, 60.2, 62.2), et **en ce que** la partie de sortie (54) possède un détecteur optique (90, 92), notamment une barrière photoélectrique, à l'aide de laquelle la partie logique (50) peut détecter au moins une position d'induit de l'au moins un induit (58) mobile.

12. Commutateur de sécurité selon la revendication 11, **caractérisé en ce que** le détecteur optique contient un émetteur de lumière (90) et un récepteur de lumière (92) qui sont disposés en-dehors du boîtier de composant (66) commun, et **en ce que** le détecteur optique possède en outre un conducteur optique (94) qui mène de l'émetteur de lumière (90) et/ou du récepteur de lumière (92) à l'au moins un induit (58) mobile.

13. Commutateur de sécurité selon l'une des revendications 1 à 12, **caractérisé en ce que** la bobine de relais (56) entraîne au moins un induit (58) mobile qui est couplé avec les contacts de relais (60.1, 62.1, 60.2, 62.2), et **en ce que** la partie logique (50) est configurée pour régler un courant de commande (78) à travers la bobine de relais (56) en fonction de l'au moins une position d'induit.

14. Commutateur de sécurité selon l'une des revendications 1 à 13, **caractérisé en ce que** la bobine de relais (56) est disposée dans l'espace entre le premier groupe (60) de contacts de relais à guidage forcé (60.1, 60.2) et le deuxième groupe (62) de contacts de relais à guidage forcé (62.1, 62.2).

15. Composant relais pour un commutateur de sécurité selon l'une des revendications 1 à 14, comprenant une bobine de relais (56) et comprenant un premier contact de relais (60.1), un deuxième contact de relais (62.1), un troisième contact de relais (60.2) et un quatrième contact de relais (62.2), et comprenant un boîtier de composant (66) dans lequel sont logés la bobine de relais (56) et les contacts de relais (60.1, 60.2, 62.1, 62.2), les premier et deuxième contacts de relais (60.1, 62.1) étant disposés électriquement en série l'un avec l'autre, les troisième et quatrième contacts de relais (60.2, 62.2) étant disposés électriquement en série l'un avec l'autre, les premier et troisième contacts de relais (60.1, 60.2) étant couplés mécaniquement l'un à l'autre afin de former un premier groupe (60) de contacts de relais à guidage forcé, les deuxième et quatrième contacts de relais (62.1, 62.2) étant couplés mécaniquement l'un à l'autre afin de former un deuxième groupe (62) de contacts de relais à guidage forcé, et la bobine de relais (56) étant couplée de manière électromagnétique avec le premier groupe (60) de contacts de relais à guidage forcé et avec le deuxième groupe (62) de contacts de relais à guidage forcé, de sorte qu'un courant de commande dans la bobine de relais (56) peut exciter conjointement le premier contact de relais (60.1), le deuxième contact de relais (62.1), le troisième contact de relais (60.2) et le quatrième contact de relais (62.2), les premier et troisième contacts de relais (60.1, 60.2) pouvant se déplacer mécaniquement séparément des deuxième et quatrième contacts de relais (62.1, 62.2).
